(19) Europäisches Patentamt
European Patent Office
Office européen des brevets

(11) **EP 4 113 129 A1**

(12) **EUROPÄISCHE PATENTANMELDUNG**

(43) Veröffentlichungstag:
**04.01.2023 Patentblatt 2023/01**

(21) Anmeldenummer: **22180837.1**

(22) Anmeldetag: **23.06.2022**

(51) Internationale Patentklassifikation (IPC):
**G01R 1/20** *(2006.01)* **G01R 35/00** *(2006.01)*

(52) Gemeinsame Patentklassifikation (CPC):
**G01R 1/203; G01R 35/005**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **28.06.2021 DE 102021116657**

(71) Anmelder: **Battrion AG**
**8600 Dübendorf (CH)**

(72) Erfinder:
• **Ebner, Martin**
**8700 Küsnacht (ZH) (CH)**
• **Bozyigit, Deniz**
**8006 Zürich (CH)**

(74) Vertreter: **Otten, Roth, Dobler & Partner mbB**
**Patentanwälte**
**Großtobeler Straße 39**
**88276 Berg / Ravensburg (DE)**

(54) **MESSVERFAHREN ZUR BESTIMMUNG DES STROMS DURCH EINEN SHUNT-WIDERSTAND**

(57) Vorgeschlagen wird ein Verfahren zur genauen Bestimmung eines elektrischen Stroms (Iin, Iin,o) mit verringertem technischem Aufwand, umfassend: Parallelschaltung eines Schaltungszweiges (2, 12) zu einem ungenauen aber strombelastbaren Shunt-Widerstand $(R_{sh})$, wobei in den Schaltungszweig (2, 12) ein im Vergleich zum Shunt-Widerstand $(R_{sh})$ genaueren aber weniger strombelastbarer Referenzwiderstand $(R_{ref})$ geschaltet wird, sodass der Schaltungszweig (2, 12) jeweils an einem Knotenpunkt (K) vor und hinter dem Shunt-Widerstand abzweigt, Erzeugung eines zeitlich veränderlichen Referenzstroms $(I_{ref}, I'_{ref}, I''_{ref})$ durch den Schaltungszweig (2, 12), Messung der Spannungen $(V'_{sh}, V''_{sh}, V'_{ref}, V''_{ref})$, die über dem Shunt-Widerstand $(R_{sh})$ und über dem Referenzwiderstand $(R_{ref})$, Bestimmung der Stromstärke (Iin, $I_{in,0}$) vor bzw. hinter dem Knotenpunkt (K).

Fig. 1

**Beschreibung**

Die Erfindung betrifft eine Messvorrichtung und ein Messverfahren zur genauen Bestimmung eines elektrischen Stroms, insbesondere bei hohen Stromstärken bis deutlich über 1000 A.

Aus dem Stand der Technik sind verschiedene Methoden bekannt, um hohe Stromstärken messen bzw. bestimmen zu können. Zur Bestimmung von Wechselströmen wird herkömmlicherweise zum Beispiel eine sog. Rogowski-Spule eingesetzt, in der eine Spannung durch das Wechselfeld eines vom zu bestimmenden Wechselstrom durchflossenen Leiters induziert wird. Neben der beschriebenen direkten Vermessung des Magnetfelds kann auch eine Bestimmung über eine Magnetfeldkompensation erreicht werden. Ein solcher Kompensationsstromsensor für Gleich- und Wechselströme arbeitet z.B. mit Hall-Sensoren, wie in der DE 42 30 939 A1 gezeigt ist. Ein weiterer Sensor nach dem Kompensationsprinzip ist ein Flux-Gate-Sensor, wie er in der EP 2 669 688 A1 beschrieben ist; letztgenannter Sensor, ein sog. DCCT-Sensor wird jedoch für spezielle Anwendungen im Zusammenhang mit Teilchenbeschleunigern eingesetzt.

Aufgabe der Erfindung ist, eine Vorrichtung bzw. ein Verfahren bereitzustellen, dass eine präzise Bestimmung der Stromstärke ermöglicht und gleichzeitig ohne größeren technischen Aufwand umgesetzt werden kann.

Die Aufgabe wird, ausgehend von einem Verfahren bzw. einer Vorrichtung der eingangs genannten Art, durch die Merkmale des Anspruchs 1 bzw. des Anspruchs 6 gelöst.

Durch die in den abhängigen Ansprüchen genannten Maßnahmen sind vorteilhafte Ausführungen und Weiterbildungen der Erfindung möglich.

Eine besondere Anwendung, für welche die nachfolgend beschriebene Erfindung eingesetzt werden kann, ist die Bestimmung der Coulomb-Effizienz von Lithium-Ionen-Batterien, mit der die Lebensdauer einer Zelle bereits nach kurzer Messdauer gut abgeschätzt werden kann. Dies ist insbesondere von Vorteil, da durch Messung der Coulomb-Effizienz der Einfluss von wichtigen Faktoren wie Temperatur, Ladestrom, Betriebsstrategie, etc. in kurzer Zeit auf die Lebensdauer ermittelt werden kann. Eine typische Anwendung ist ferner die genaue Bestimmung eines Shunt-Widerstands während dieser zur Strommessung genutzt wird.

Der Erfindung liegt die Idee zugrunde, die Stromstärke zu bestimmen, indem diese in Abhängigkeit von Größen formuliert wird, die sehr präzise gemessen werden können. Da die vorgeschlagene Vorrichtung bzw. das vorgeschlagene Verfahren aber dazu bestimmt ist, sehr hohe Stromstärken von weit mehr als 100 A, sogar über 1000 A zu messen, können aber geringe systematische Fehler bereits die Genauigkeit einer Messung zerstören. Aufgrund der Höhe der zu bestimmenden Stromstärke sind unmittelbare Messungen kaum möglich. Ferner würden bereits geringe Fehler, z. B. infolge einer Temperaturdrift des Eigenwiderstands eines etwaigen Amperemeters, bereits zu inakzeptablen Fehlern führen. Mit der vorliegenden Erfindungen können beispielsweise Stromstärken von 100 A mit einer Genauigkeit besser als 1 mA bestimmt werden.

Erfindungsgemäß wird ein Schaltungszweig zu einem ungenauen, aber strombelastbaren Shunt-Widerstand parallel geschaltet, wobei gleichzeitig bei der Bestimmung auch der Shunt-Widerstand selbst bestimmt werden kann. Dieser Schaltungszweig umfasst einen im Vergleich zum Shunt-Widerstand möglichst genauen, aber weniger strombelastbaren Referenzwiderstand, d.h. es fließen in der Regel Stromstärken durch den Referenzwiderstand, die geringer, insbesondere deutlich geringer sind als diejenigen, mit denen der Shunt-Widerstand belastet wird.

- Die Erfindung besitzt gegenüber einer herkömmlichen Rogowski-Spule z.B. den Vorteil, dass die Messgenauigkeit nicht von der Positionierung einer Spule relativ zum Leiter und somit von der Feldverteilung eines Magnetfelds abhängt.

- Außerdem besteht beim Einsatz von Magnetfeldmessungen, wie es u.a. die Rogowski-Spule vorsieht, eine hohe Anfälligkeit, dass die Messung durch sonstige äußere Magnetfelder, insbesondere auch dem Erdmagnetfeld, verfälscht wird. Auch dieser Störeffekt kann erfindungsgemäß ausgeschlossen werden.

- Darüber hinaus ermöglicht die Erfindung die Vermessung von Gleichströmen, da - im Unterschied zu anderen, induktiv arbeitenden Sensoren - keine Induktionsspannung erzeugt werden muss. Insgesamt sind auch die Messergebnisse bei der Erfindung im Allgemeinen vorteilhafterweise unabhängig vom zeitlichen Stromverlauf.

- Zudem besitzt die Erfindung den Vorteil, dass sie unabhängig von zusätzlichen Verstärker- bzw. Integrator-Schaltungen mit den damit verbundenen Nachteilen von (Offset-) Stabilität, Abweichungen von linearem Verhalten usw. arbeiten kann.

- Ausserdem besitzt die Erfindung den Vorteil, dass die Strommessung sehr schnell stattfinden kann.

Durch die Parallelschaltung wird vor und hinter dem Shunt-Widerstand ein Knotenpunkt gebildet.

Um ein Gleichungssystem bilden zu können, bei dem zum Beispiel die Stromstärke vor bzw. hinter dem Knotenpunkt als Größe unabhängig von der Größe des unbekannten oder zumindest nicht genau bekannten Shunt-Widerstands formuliert wird, wird ein zeitlich veränderlicher Referenzstrom durch den Schaltungszweig erzeugt.

Durch den Shunt-Widerstand fließen somit zwei einander entgegengesetzte Ströme, nämlich:

- der Stromfluss, der sich am Knotenpunkt verzweigt, wobei der durch den Shunt-Widerstand laufende Teil sehr viel größer ist als der Teil, der durch den Referenzwiderstand fließt, sowie
- der durch die Referenzstromquelle erzeugte Strom, der (den Knotenpunkt passiert) und über den Shunt-Widerstand wieder zurückfließt.

Diese erfindungsgemäße Maßnahme ermöglicht es, zum Beispiel die Stromstärke in Abhängigkeit von den Spannungen, die über dem Shunt-Widerstand und dem Referenzwiderstand abfallen, und in Abhängigkeit vom relativ genau bekannten Referenzwiderstand zu formulieren. Spannungsmessungen können in der Regel sehr präzise durchgeführt werden. Die Eigenwiderstände von Voltmetern sind derart hoch, dass der Verlust durch einen Stromfluss durch das Voltmeter vernachlässigbar ist.

Der Referenzstrom wird gemäß der Erfindung verändert, um genügend Variablen zu haben, um das Gleichungssystem lösen zu können. Eine Option, den Referenzstrom zu verändern, besteht darin, den Schaltungszweig abzuschalten. Dies kann, muss aber nicht durch einen mechanischen Schalter realisiert werden. Stattdessen kann auch ein elektronischer Schalter, z.B. ein Transistor, vor allem ein Feldeffekt-Transistor eingesetzt werden, sodass Spannungsspitzen beim Schalten, korrodierte Kontakte oder dergleichen vermieden werden können.

Stattdessen kann auch eine zusätzliche Referenzstromquelle in den Schaltungszweig geschaltet werden. Dadurch können noch mehr Werte als nur Paare erzeugt werden; die Genauigkeit kann erhöht werden.

Um die Genauigkeit noch weiter zu erhöhen, können weitere Störquellen eliminiert werden, indem die Referenzstromquelle galvanisch isoliert wird. Hierzu kann eine vom Netz unabhängige Stromquelle verwendet werden. Grundsätzlich ist es auch denkbar, die Stromquelle über einen Trenntransformator oder einer ähnlichen Schaltung mit Energie zu versorgen. Völlig unabhängig ist aber eine Stromquelle, die eine eigenständige Versorgung ermöglicht. Hierfür eignet sich bei einer Weiterbildung der Erfindung eine Solarzelle sehr gut. Um eine stabile Stromquelle zu erhalten, kann die Solarzelle mit einer eigenen Lichtquelle beleuchtet werden. Vorgeschlagen wird zum Beispiel eine Kombination aus einer Solarzelle, die auf einer Platine vormontiert ist, und eine Infrarot-Leuchtdiode (IR-LED) mit hoher Intensität. Die Stromquelle ist in diesem Fall vollständig galvanisch getrennt. Eine solche Stromquelle liefert hohe Ströme, auch unter Kurzschlussbedingungen.

Um einen Referenzstrom mit veränderbarer Stromstärke zu erhalten, kann die Lichtquelle, mit der die Solarzelle beschienen wird, verändert werden. Ferner können auch zwei Solarzellen unabhängig voneinander beleuchtet und entgegengesetzt geschaltet bzw. betrieben werden, sodass durch Änderung der Helligkeit einer bzw. beider Lichtquellen die Referenzstromstärke sowie die Stromrichtung geändert werden kann. Die beiden Lichtquellen können z.B. abwechselnd beschienen werden. Soll der parallelgeschaltete Schaltungszweig zur Veränderung der Stromstärke abgetrennt werden, so kann auch der Schaltungszweig über einen Transistor bzw. über einen Feldeffekttransistor geführt werden, der dann durch den Stromfluss der Solarzelle gesperrt wird.

Zur Bestimmung des Shunt-Widerstands kann bei einer vorteilhaften Ausführungsform der Erfindung eine Brückenschaltung eingesetzt werden. Der zu bestimmende Shunt-Widerstand wird in den Brückenzweig geschaltet. Durch eine Brückenschaltung kann in vorteilhafter Weise auch die Polarität des Referenzstroms umgedreht werden. Die Widerstandbestimmung erfolgt über die Bestimmung der Stromstärken in den Teilzweigen. Auf diese Weise kann der Referenzstrom mit wechselnder Polarität sehr symmetrisch um 0 V gewählt werden, wodurch die Messgenauigkeit erhöht werden kann. Das Umschalten der Polarität kann, insbesondere bei Schaltung über Feldeffekttransistoren, sehr schnell und präzise vorgenommen werden.

Die Vorteile einer Brückenschaltung könnten darin bestehen, dass eine präzisere Symmetrie beim Polaritätswechsel des Referenzstroms bzw. ein genauerer 50% Tastgrad (Englisch: dutycycle) möglich ist. Für die Referenzstromquelle ist dann grundsätzlich auch nur eine Solarzelle notwendig.

Ausführungsbeispiel:

Ausführungsbeispiele der Erfindung sind in den Zeichnungen dargestellt und werden nachstehend unter Angabe weiterer Einzelheiten und Vorteile näher erläutert. Im Einzelnen zeigen:

Fig. 1:     ein schematisches Schaltbild einer Messvorrichtung gem. der Erfindung mit zuschaltbarem Schaltungszweig,

Fig. 2:     ein schematisches Schaltbild einer Messvorrichtung gem. der Erfindung mit änderbarer Referenzstromquelle,

Fig. 3: ein schematisches Schaltbild zur Realisierung des Schalters für eine Messvorrichtung gem. Fig. 1, sowie

Fig. 4-5: schematische Schaltbilder zur Realisierung der Referenzstromquelle für Messvorrichtungen gem. Fig. 2, hier mit Solarzellen zur galvanischen Trennung.

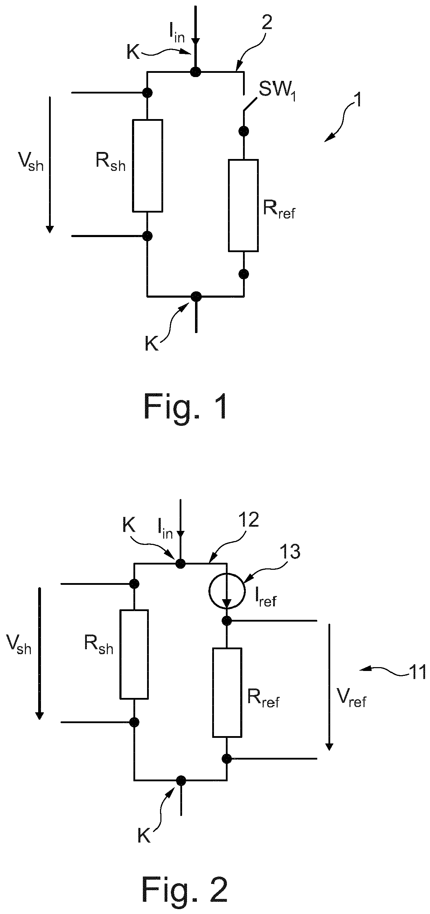

Figur 1 zeigt ein schematisches Schaltbild einer Messvorrichtung 1 gem. der Erfindung mit einem Schalter $SW_1$ zum Hinzuschalten bzw. Abtrennen eines Schaltungszweigs 2.

Die Situation, in welcher der Schaltungszweig 2 hinzugeschaltet ist, d.h. der Schalter $SW_1$ ist geschlossen, wird mit einem "Strich(')" bezeichnet, die Situation bei geöffnetem Schalter $SW_1$ mit "zwei Strichen(")" in den Variablen. Bei geöffnetem Schalter $SW_1$ ist

$$I''_{ref} = 0$$

bei geschlossenem Schalter $SW_1$ gilt:

$$I'_{ref} = I_{ref,0}$$

Die Widerstände, also Shunt- und Referenzwiderstand, werden für die kurze Zeit zwischen den Schaltwechseln als konstant angenommen:

$$R'_{sh} = R''_{sh} = R_{sh,0}$$

sowie

$$R'_{ref} = R''_{ref} = R_{ref,0}$$

Ferner wird die Schaltung so betrieben (die Schaltwechsel werden so schnell durchgeführt), dass vor bzw. hinter dem Knotenpunkt, an dem sich der Weg in den Zweig durch den Shunt-Widerstand und durch den Schaltungszweig mit Referenzwiderstand verzweigen, die Stromstärken Iin als konstant angenommen werden können, d.h.:

$$I'_{in} = I''_{in} = I_{in,0}$$

Für geschlossenen Schalter $SW_1$ ergibt sich:

$$V'_{sh} = \frac{R'_{sh} \cdot R'_{ref}}{R'_{sh} + R'_{ref}} I'_{in} = \frac{R_{sh,0} \cdot R_{ref,0}}{R_{sh,0} + R_{ref,0}} I_{in,0}$$

während bei geöffnetem Schalter $SW_1$ gilt:

$$V''_{sh} = R''_{sh} \cdot I''_{in} = R_{sh,0} \cdot I_{in,0}$$

Insgesamt folgt daraus schließlich für $I_{in}$:

$$V'_{sh} = \frac{\frac{V''_{sh}}{I_{in,0}} \cdot R_{ref,0}}{\frac{V''_{sh}}{I_{in,0}} + R_{ref,0}} I_{in,0} \rightarrow I_{in,0} = \frac{1}{R_{ref,0}} \cdot \frac{V'_{sh} \cdot V''_{sh}}{(V''_{sh} - V'_{sh})}$$

Die Berechnung erfolgt hier unter der Annahme, dass sich der Schalter $SW_1$ wie ein mechanischer Schalter verhält und im geöffneten Zustand einen praktisch unendlich großen Widerstand und im geschlossenen Zustand keinen ohmschen Widerstand aufweist.

Im Übrigen sind in der Regel hohe Stromstärken $I_{in}$ zu erwarten.

Figur 2 zeigt eine analoge Ausführungsform zu Figur 1 (Messvorrichtung 11), bei der jedoch nicht der Stromfluss durch den Schaltungszweig 12 völlig unterbrochen wird, sondern bei dem die Polarität des Referenzstroms $I_{ref}$ wechselt (Phase 1, gekennzeichnet mit einem "Strich(')", umgekehrt zu Phase 2, gekennzeichnet mit einem "Strich(")"), d.h.

$$I'_{ref} = +I_{ref,0}$$

und

$$I''_{ref} = -I_{ref,0}$$

Verwendet wird zu diesem Zweck eine Stromquelle 13, die in den Schaltungszweig 12 in Serie zum Referenzwiderstand $R_{ref}$ geschaltet ist und deren Polarität gewechselt werden kann. Ferner wird der Stromfluss so eingestellt, dass Iin konstant bleibt, also:

$$I'_{in} = I''_{in} = I_{in,0}$$

Unabhängig von der Schaltungssituation wird für die kurze Zeit zwischen den Schaltwechseln der Shunt- und Referenzwiderstand als konstant angenommen, d.h.

$$R'_{sh} = R''_{sh} = R_{sh,0}$$

sowie

$$R'_{ref} = R''_{ref} = R_{ref,0}$$

Daraus folgt schließlich für die beiden Phasen mit unterschiedlicher Polarität der Referenzstromstärke:

$$V'_{sh} = \left(I'_{in} - I'_{ref}\right) \cdot R'_{sh} = \left(I_{in,0} - I_{ref,0}\right) \cdot R_{sh,0}$$

$$V'_{ref} = I'_{ref} \cdot R'_{ref} = I_{ref,0} \cdot R_{ref,0}$$

und

$$V''_{sh} = \left(I''_{in} - I''_{ref}\right) \cdot R''_{sh} = \left(I_{in,0} + I_{ref,0}\right) \cdot R_{sh,0}$$

$$V''_{ref} = I''_{ref} \cdot R''_{ref} = -I_{ref,0} \cdot R_{ref,0}$$

Umformungen ergeben schließlich:

$$\frac{V'_{ref} - V''_{ref}}{2R_{ref,0}} = \frac{I_{ref,0} \cdot R_{ref,0} + I_{ref,0} \cdot R_{ref,0}}{2R_{ref,0}} = I_{ref,0}$$

und ferner

$$\frac{V''_{sh} + V'_{sh}}{V''_{sh} - V'_{sh}} = \frac{\left(I_{in,0} + I_{ref,0}\right) \cdot R_{sh,0} + \left(I_{in,0} - I_{ref,0}\right) \cdot R_{sh,0}}{\left(I_{in,0} + I_{ref,0}\right) \cdot R_{sh,0} - \left(I_{in,0} - I_{ref,0}\right) \cdot R_{sh,0}} = \frac{I_{in,0}}{I_{ref,0}}$$

woraus für die Stromstärke Iin gefolgert wird:

$$\frac{V'_{ref} - V''_{ref}}{2R_{ref,0}} \cdot \frac{V''_{sh} + V'_{sh}}{V''_{sh} - V'_{sh}} = I_{in,0}$$

Bis auf einen Faktor 1/2 ergibt sich also eine analoge Formel zum Ausführungsbeispiel nach Figur 1.
Gemeinsam ist den Ausführungsbeispielen nach den Figuren 1 und 2, dass nur Spannungen, die auch sehr genau vermessen werden können, benötigt werden und gemessen werden müssen. Der Referenzwiderstand ist ebenfalls sehr genau bekannt.
Eine genaue Bestimmung des Messstroms $I_{in,0}$ sowie des Shunt-Widerstands $R_{sh,0}$ ist auch möglich, wenn die Absolutwerte des Referenzstroms während der zwei Phasen nicht identisch sind, d.h.:

$$\left|I'_{ref}\right| \neq \left|I''_{ref}\right|$$

Dabei gelten folgende Beziehungen:

$$I'_{ref} = \frac{V'_{ref}}{R'_{ref}} = \frac{V'_{ref}}{R_{ref,0}}$$

$$I''_{ref} = \frac{V''_{ref}}{R''_{ref}} = \frac{V''_{ref}}{R_{ref,0}}$$

$$R_{sh,0} = \frac{V''_{sh} - V'_{sh}}{\left(I_{in,0} - I''_{ref}\right) - \left(I_{in,0} - I'_{ref}\right)} = \frac{V''_{sh} - V'_{sh}}{I'_{ref} - I''_{ref}}$$

daraus folgt:

$$R_{sh,0} = R_{ref,0} \frac{V''_{sh} - V'_{sh}}{V'_{ref} - V''_{ref}}$$

Damit kann für jeden Schaltzyklus der aktuelle Shunt-Widerstand rein aus den messbaren Spannungen sowie dem bekannten Referenzwiderstand bestimmt werden.

Werden die ermittelten Werte des Shunt-Widerstands über mehrere Schaltzyklen die zu Zeitpunkten $t=t_1$, $t=t_2$, etc. ermittelt werden aneinandergereiht, so kann ein Shunt-Widerstands-Signal $R_{sh,0}(t)$ gebildet werden:

$$R_{sh,0}(t) = \{R_{sh,0}|t = t_1, \quad R_{sh,0}|t = t_2 \quad ...\}$$

Es ist zu erwarten, dass dieses Shunt-Widerstands-Signal aufgrund von Rauschen bei den Spannungsmessungen zur Bestimmung von $V'_{sh}$, $V''_{sh}$, $V'_{ref}$, und $V''_{ref}$ wiederum ein Rauschen, d.h. schnelle kleine zufällige Änderungen, aufweist. Da zu erwarten ist, dass die durch Erwärmung des Shunt-Widerstands aufgrund der Strombelastung zu erwartende Widerstandsänderung jedoch eher langsam, z.B. über einen Zeitraum von einigen Sekunden stattfindet, kann das Shunt-Widerstands-Signal zur Verbesserung der Genauigkeit auch gefiltert werden. Durch Applizierung einer Filterfunktion f auf das Shunt-Widerstands-Signal $R_{sh,0}(t)$ ergibt sich das gefilterte Shunt-Widerstands-Signal $R^*_{sh,0}(t)$:

$$R^*_{sh,0}(t) = f\left(R_{sh,0}(t)\right)$$

Als geeignete Filterfunktion f kann zum Beispiel ein Mittelwertfilter, Medianfilter, Tiefpassfilter, oder andere in der Signalverarbeitung übliche Filterfunktion genutzt werden.

Der Messstrom $I_{in,0}$ kann dann mittels der folgenden Gleichung ermittelt werden:

$$I_{in,0} = \frac{1}{2}\left(\left(\frac{V''_{sh}}{R^*_{sh,0}(t)} + I''_{ref}\right) + \left(\frac{V'_{sh}}{R^*_{sh,0}(t)} + I'_{ref}\right)\right)$$

Bzw.:

$$I_{in,0} = \frac{1}{2}\left(\left(\frac{V''_{sh}}{R^*_{sh,0}(t)} + \frac{V''_{ref}}{R_{ref,0}}\right) + \left(\frac{V'_{sh}}{R^*_{sh,0}(t)} + \frac{V'_{ref}}{R_{ref,0}}\right)\right)$$

Die Messvorrichtung gem. der Erfindung kann also dazu verwendet werden um:

- eine Stromstärke sehr genau zu bestimmen,
- auch wenn es sich um eine sehr hohe Stromstärke handelt,
- daneben auch präzise den unbekannten Shunt-Widerstand zu vermessen.

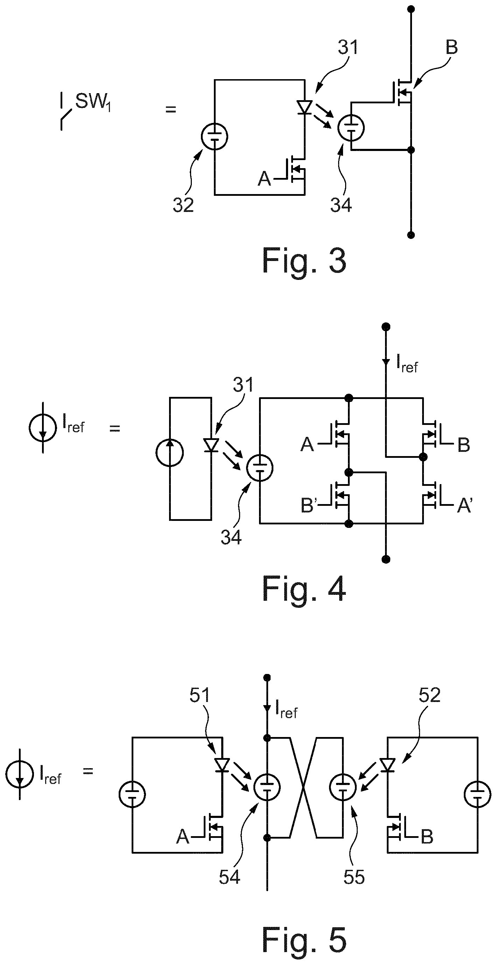

Figur 3 zeigt eine schematische Darstellung, wie der Schalter $SW_1$ implementiert werden kann, der für die Ausführungsform nach Figur 1 benötigt wird: Die Leuchtdiode 31 (Abstrahlung im Infrarot-Bereich) wird von einer Spannungsquelle 32 gespeist; das Schalten des Kreises erfolgt über den Feldeffekttransistor A.

Um eine vollständige galvanische Trennung durchzuführen, kann als Stromquelle z.B. eine Solarzelle verwendet werden. Ähnlich einer Optokoppler-Schaltung bescheint die Leuchtdiode 31 eine Solarzelle 34, welche wiederum einen Feldeffekttransistor B schaltet, sodass dieser entweder sperrt oder zum Durchlass veranlasst.

Schließlich zeigen die Figuren 4 und 5 jeweils Ausführungsbeispiele, bei denen die Referenzstromquelle 13 hinsichtlich ihrer Stromstärke verändert werden kann, indem die Polarität des Stromes wechselt. Die Ausführungsvariante nach Figur 4 benutzt eine Brückenschaltung (auch H-Schaltung genannt), um die Polarität zu wechseln. Je nachdem, ob die Feldeffekttransistor-Paare A-A' oder B-B' jeweils leiten oder sperren, trägt der Strom der Solarzelle zur Erhöhung oder zum Herabsetzen der Referenzstromstärke $I_{ref}$ bei. Auch hier wird die Solarzelle 34 von einer Infrarot-Leuchtdiode beschienen. Das Schalten zum Verändern der Referenzstromstärke $I_{ref}$ erfolgt allein durch die Transistoren A-A' bzw. B-B' im Schaltungszweig, der auch die Solarzelle 34 umfasst.

Stattdessen können aber auch zwei Solarzellen 54, 55 antiparallel geschaltet werden. Die Polarität hängt aus Sicht des Referenzstroms $I_{ref}$ davon ab, welche der Solarzellen 54, 55 beschienen wird.

Bezugszeichenliste:

| | |
|---|---|
| 1 | Messvorrichtung |
| 2 | Schaltungszweig |
| 11 | Messvorrichtung |
| 12 | Schaltungszweig |
| 13 | Referenzstromquelle |
| 31 | Leuchtdiode |
| 32 | Spannungsquelle |
| 34 | Solarzelle |
| 51 | Infrarot-Leuchtdiode |
| 52 | Infrarot-Leuchtdiode |
| 54 | Solarzelle |
| 55 | Solarzelle |
| A | Feldeffekttransistor |
| A' | Feldeffekttransistor |
| B | Feldeffekttransistor |
| B' | Feldeffekttransistor |

$I_{ref,0}$    Referenzstromstärke

$I'_{ref}$    Referenzstromstärke (Phase 1)

$I''_{ref}$    Referenzstromstärke (Phase 2)

$I'_{in}$    Stromstärke (Phase 1)

$I''_{in}$    Stromstärke (Phase 2)

$I_{in}$    Stromstärke

$I_{in,0}$    Stromstärke

K    Knotenpunkt

$R'_{sh}$    Shunt-Widerstand (Phase 1)

$R''_{sh}$    Shunt-Widerstand (Phase 2)

$R_{sh,0}$    Shunt-Widerstand

$R_{sh}$  Shunt-Widerstand

$R_{sh,0}(t)$  Shunt-Widerstands-Signal

$R^*_{sh,0}(t)$  gefiltertes Shunt-Widerstands-Signal

$f$  Filterfunktion

$R'_{ref}$  Referenzwiderstand (Phase 1)

$R''_{ref}$  Referenzwiderstand (Phase 2)

$R_{ref,0}$  Referenzwiderstand **$R_{ref}$** Referenzwiderstand

$V'_{sh}$  Spannung über Shunt-Widerstand (Phase 1)

$V''_{sh}$  Spannung über Shunt-Widerstand (Phase 2)

$SW_1$  Schalter

**Patentansprüche**

1. Verfahren zur genauen Bestimmung eines elektrischen Stroms ($I_{in}$, $I_{in,0}$), umfassend:

   • Parallelschaltung eines Schaltungszweiges (2, 12) zu einem ungenauen aber strombelastbaren Shunt-Widerstand ($R_{sh}$), wobei in den Schaltungszweig (2, 12) ein im Vergleich zum Shunt-Widerstand ($R_{sh}$) genaueren aber weniger strombelastbarer Referenzwiderstand ($R_{ref}$) geschaltet wird, sodass der Schaltungszweig (2, 12) jeweils an einem Knotenpunkt (K) vor und hinter dem Shunt-Widerstand abzweigt,
   • Erzeugung eines zeitlich veränderlichen Referenzstroms ($I_{ref}$, $I'_{ref}$, $I''_{ref}$) durch den Schaltungszweig (2, 12),
   • Messung der Spannungen ($V'_{sh}$, $V''_{sh}$, $V'_{ref}$, $V''_{ref}$), über dem Shunt-Widerstand ($R_{sh}$) und über dem Referenzwiderstand ($R_{ref}$)
   • Bestimmung der Stromstärke ($I_{in}$, $I_{in,0}$) vor bzw. hinter dem Knotenpunkt (K).

2. Verfahren nach Anspruch 1, **dadurch gekennzeichnet, dass** der Referenzstrom ($I_{ref}$, $I'_{ref}$, $I''_{ref}$) verändert wird, indem der Schaltungszweig (2, 12) parallel zum Shunt-Widerstand ($R_{sh}$) dazugeschaltet und wieder getrennt wird, und/oder die Spannungen ($V'_{sh}$, $V''_{sh}$, $V'_{ref}$, $V''_{ref}$) mit und ohne zugeschaltetem Schaltungszweig (2, 12) gemessen werden.

3. Verfahren nach einem der vorgenannten Ansprüche, **dadurch gekennzeichnet, dass** in den Schaltungszweig (2, 12) eine Referenzstromquelle (13) geschaltet und dadurch der Stromfluss ($I_{ref}$, $I'_{ref}$, $I''_{ref}$) im Schaltungszweig (2, 12) erhöht und der Stromfluss ($I_{sh}$, $I'_{ref}$, $I''_{ref}$) durch den Shunt-Widerstand ($R_{sh}$) verringert wird.

4. Verfahren nach einem der vorgenannten Ansprüche, **dadurch gekennzeichnet, dass** die Stromstärke ($I_{in}$, $I_{in,0}$) vor bzw. hinter dem Knotenpunkt (K) auch bei zeitlicher Veränderung des Referenzstroms ($I_{ref}$, $I'_{ref}$, $I''_{ref}$) durch den Schaltungszweig (2, 12) konstant gehalten wird.

5. Verfahren nach einem der vorgenannten Ansprüche, **dadurch gekennzeichnet, dass** eine Serie von Werten für den Shunt-Widerstand und/oder die Stromstärke in Abhängigkeit von den gemessenen Spannungen, die über dem Shunt-Widerstand und dem Referenzwiderstand abfallen, bestimmt und anschließend gefiltert wird, insbesondere mit einem Mittelwertfilter und/oder Medianfilter und/oder Tiefpassfilter.

6. Messvorrichtung (1) zur genauen Bestimmung eines elektrischen Stroms ($I_{in}$), umfassend eine Schaltung die einen ungenauen aber strombelastbaren Shunt-Widerstand ($R_{sh}$) sowie einen Schaltungszweig (2, 12) aufweist, der parallel zu dem Shunt-Widerstand ($R_{sh}$) anschließbar und/oder schaltbar ist, wobei in den Schaltungszweig (2, 12) ein im Vergleich zum Shunt-Widerstand ($R_{sh}$) genauerer, aber weniger strombelastbarer Referenzwiderstand ($R_{ref}$) und mindestens ein Schalter ($SW_1$) und/oder eine Stromquelle (13) zur Erzeugung eines Referenzstroms ($I_{ref}$, $I'_{ref}$, $I''_{ref}$) geschaltet ist, sodass sich der Stromfluss ($I_{in}$, $I_{in,0}$) am Knotenpunkt (K), an dem der Schaltungszweig (2, 12) parallel zum Shunt-Widerstand ($R_{sh}$) geschaltet ist, sich in die zwei Wege durch den Shunt-Widerstand ($R_{sh}$) und

den Referenzwiderstand ($R_{ref}$) verzweigen und durch den Schaltungszweig (2, 12) ein Referenzstrom ($I_{ref}$, $I'_{ref}$, $I''_{ref}$) fließen kann, wobei der Schaltungszweig (2, 12) dazu ausgebildet ist, einen zeitlich veränderlichen Referenzstrom ($I_{ref}$, $I'_{ref}$, $I''_{ref}$) zu bewirken, wobei die Messvorrichtung (1) dazu ausgebildet ist, die Spannungen ($V'_{sh}$, $V''_{sh}$, $V'_{ref}$, $V'_{ref}$) zu messen, die jeweils über dem Shunt-Widerstand ($R_{sh}$) und über dem Referenzwiderstand ($R_{ref}$) abfällt, um daraus die Stromstärke ($I_{in}$, $I_{in,0}$) zu bestimmen, die zum und/oder vom jeweiligen Knotenpunkt (K) weg fließt, an dem sich der Schaltungszweig (2, 12) abzweigt.

7. Messvorrichtung (1) nach Anspruch 5, **dadurch gekennzeichnet, dass** der Schaltungszweig (2, 12) einen Schalter ($SW_1$) aufweist, um den Stromfluss ($I_{ref}$, $I'_{ref}$, $I''_{ref}$) durch den Schaltungszweig (2, 12) zu unterbrechen und/oder zu veranlassen, um so den zeitlich veränderlichen Referenzstrom ($I_{ref}$, $I'_{ref}$, $I''_{ref}$) zu bewirken.

8. Messvorrichtung (1) nach einem der Ansprüche 5 oder 6, **dadurch gekennzeichnet, dass** der Schaltungszweig (2, 12) eine Referenzstromquelle (13) umfasst, um so den zeitlich veränderlichen Referenzstrom ($I_{ref}$, $I'_{ref}$, $I''_{ref}$) zu bewirken.

9. Messvorrichtung (1) nach einem der Ansprüche 5 bis 7, **dadurch gekennzeichnet, dass** die Referenzstromquelle (13) im Schaltungszweig (2, 12) in Serie zum Referenzwiderstand ($R_{ref}$) geschaltet ist, um so den zeitlich veränderlichen Referenzstrom ($I_{ref}$, $I'_{ref}$, $I''_{ref}$) zu bewirken.

10. Messvorrichtung (1) nach einem der Ansprüche 5 bis 8, **dadurch gekennzeichnet, dass** der Schalter ($SW_1$) durch mindestens einen Transistor (A, A', B, B'), insbesondere eines Feldeffekt-Transistors, ausgestaltet ist.

11. Messvorrichtung (1) nach einem der Ansprüche 5 bis 9, **dadurch gekennzeichnet, dass** die Messvorrichtung (1) dazu ausgebildet ist, dass die Stromstärke ($I_{in}$, $I_{in,0}$) vor bzw. hinter dem Knotenpunkt (K) auch bei zeitlicher Veränderung des Referenzstroms ($I_{ref}$, $I'_{ref}$, $I''_{ref}$) durch den Schaltungszweig (2, 12) konstant gehalten wird.

12. Messvorrichtung (1) nach einem der Ansprüche 5 bis 10, **dadurch gekennzeichnet, dass** die Referenzstromquelle (13) galvanisch isoliert ist.

13. Messvorrichtung (1) nach einem der Ansprüche 5 bis 11, **dadurch gekennzeichnet, dass** die Referenzstromquelle (13) im Schaltungszweig mindestens eine Solarzelle (34, 54, 55), insbesondere einer durch eine Licht emittierenden Diode (LED, 31, 51) erzeugte Infrarot-strahlung ausgesetzten Solarzelle (34, 54, 55), enthält.

14. Messvorrichtung (1) nach einem der Ansprüche 5 bis 12, **dadurch gekennzeichnet, dass** der zeitlich veränderliche Referenzstrom ($I_{ref}$, $I'_{ref}$, $I''_{ref}$) mittels mindestens eines Schalters ($SW_1$), bevorzugt eines Transistors, insbesondere eines Feldeffekt-Transistors (A, A', B, B'), insbesondere mehrerer Transistoren in Brückenschaltung aus einer zeitlich wenig veränderlichen Stromquelle, insbesondere einer Solarzelle (34, 54, 55), erzeugt wird.

15. Messvorrichtung (1) nach einem der vorgenannten Ansprüche 5 bis 13, **dadurch gekennzeichnet, dass** die Referenzstromquelle (13) so geschaltet ist, dass der Stromfluss ($I_{ref}$, $I'_{ref}$, $I''_{ref}$) im Schaltungszweig (2, 12) erhöht und der Stromfluss ($I_{ref}$, $I'_{ref}$, $I''_{ref}$) durch den Shunt-Widerstand ($R_{sh}$) verringert wird.

Fig. 1

Fig. 2

Fig. 3

Fig. 4

Fig. 5

EP 4 113 129 A1

<table>
<tr><td colspan="2" align="center">Europäisches Patentamt<br>European Patent Office<br>Office européen des brevets</td><td align="center"><b>EUROPÄISCHER RECHERCHENBERICHT</b></td><td align="center"><b>Nummer der Anmeldung</b><br><br><b>EP 22 18 0837</b></td></tr>
</table>

<table>
<tr><td colspan="4" align="center"><b>EINSCHLÄGIGE DOKUMENTE</b></td></tr>
<tr><td>Kategorie</td><td align="center">Kennzeichnung des Dokuments mit Angabe, soweit erforderlich,<br>der maßgeblichen Teile</td><td>Betrifft<br>Anspruch</td><td><b>KLASSIFIKATION DER<br>ANMELDUNG (IPC)</b></td></tr>
<tr><td>X<br><br>A</td><td><b>EP 3 417 305 B1</b> (CONTINENTAL AUTOMOTIVE<br>GMBH [DE]) 20. Januar 2021 (2021-01-20)<br>* Abbildungen 1,2 *<br>* Absatz [0017] – Absatz [0018] *<br>* Absatz [0020] *<br>* Absatz [0025] *<br>* Absatz [0044] *<br>* Absatz [0048] *<br>* Absatz [0070] – Absatz [0078] *<br>-----</td><td>1-8,10,<br>14<br>9,12,13</td><td>INV.<br>G01R1/20<br>G01R35/00</td></tr>
<tr><td>X</td><td><b>DE 10 2011 006304 A1</b> (SB LIMOTIVE CO LTD<br>[KR]; SB LIMOTIVE GERMANY GMBH [DE])<br>4. Oktober 2012 (2012-10-04)<br>* Abbildungen 2-3 *<br>* Absatz [0004] – Absatz [0013] *<br>* Absatz [0019] – Absatz [0022] *<br>-----</td><td>1-15</td><td></td></tr>
<tr><td>A</td><td><b>EP 3 640 651 A1</b> (CONTINENTAL AUTOMOTIVE<br>GMBH [DE]) 22. April 2020 (2020-04-22)<br>* das ganze Dokument *<br>-----</td><td>1-15</td><td><b>RECHERCHIERTE<br>SACHGEBIETE (IPC)</b><br><br>G01R</td></tr>
<tr><td colspan="2">Der vorliegende Recherchenbericht wurde für alle Patentansprüche erstellt</td><td></td><td></td></tr>
<tr><td align="center">Recherchenort<br><b>München</b></td><td align="center">Abschlußdatum der Recherche<br><b>18. November 2022</b></td><td colspan="2" align="center">Prüfer<br><b>Nguyen, Minh</b></td></tr>
</table>

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus anderen Gründen angeführtes Dokument
........
& : Mitglied der gleichen Patentfamilie, übereinstimmendes
  Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 22 18 0837

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

18-11-2022

| Im Recherchenbericht angeführtes Patentdokument | Datum der Veröffentlichung | Mitglied(er) der Patentfamilie | Datum der Veröffentlichung |
|---|---|---|---|
| EP 3417305 B1 | 20-01-2021 | DE 102016202500 A1<br>EP 3417305 A1<br>WO 2017140874 A1 | 24-08-2017<br>26-12-2018<br>24-08-2017 |
| DE 102011006304 A1 | 04-10-2012 | KEINE | |
| EP 3640651 A1 | 22-04-2020 | CN 111044768 A<br>EP 3640651 A1<br>US 2020116764 A1 | 21-04-2020<br>22-04-2020<br>16-04-2020 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4230939 A1
- EP 2669688 A1